# EUROPÄISCHE PATENTANMELDUNG

(11) **EP 0 889 526 A2**
(43) Veröffentlichungstag der Anmeldung: **07.01.1999**
(21) Anmeldenummer: 98810529.2
(22) Anmeldetag: 10.06.1998
(51) Int. Cl.: H01L 25/07, H01L 25/16

(54) **Leistungshalbleitermodul mit geschlossenen Submodulen**

(30) Priorität: 23.06.1997 DE 19726534
(71) Anmelder: Asea Brown Boveri AG, 5401 Baden (CH)
(72) Erfinder: Stockmeier, Thomas Dr., 5706 Boniswil (CH)
(74) Vertreter: Lück, Gert, Dr.

(57) **Zusammenfassung**

Die vorliegende Erfindung offenbart ein Leistungshalbleitermodul 10 mit gekapselten Submodulen 1, das z. B. für Leistungsschalter, Gleichrichter, o. ä. in Industrie- oder Traktionsantrieben geeignet ist. Die Submodule 1 besitzen einen sandwichartigen Aufbau aus einem Keramiksubstrat, einem oder wenigen Leistungshalbleiterchips und einer Molybdänscheibe und sind in Plastik vergossen. Sie werden in Steckplätzen 19 auf einer gemeinsamen Bodenplatte 11 gehaltert und über eine Stapelanordnung von Leitern 12, 14, 18 kontaktiert. Die Halterung und Kontaktierung der Submodule 1 erfolgt reversibel über Druckkontakte 15, 16, 20, Klemmkontakte 21 o. ä. Wichtige Vorteile des Leistungshalbleitermoduls 10 betreffen den einfachen und einfach skalierbaren Aufbau, die verbesserte thermische Wechselbelastbarkeit und die Robustheit und leichte Auswechselbarkeit der Submodule.

## Beschreibung

### TECHNISCHES GEBIET

Die vorliegende Erfindung bezieht sich auf das Gebiet der Leistungselektronik. Sie geht aus von einem Leistungshalbleitermodul mit einer Mehrzahl von Submodulen nach dem Oberbegriff des Anspruchs 1.

### STAND DER TECHNIK

Leistungshalbleiter für Industrie-, Traktions- und andere Anwendungen sind häufig modular aus mehreren Leistungshalbleiterbauelementen, wie z. B. Thyristoren, GTOs, MCTs, Leistungsdioden, IGBTs oder MOSFETS, aufgebaut. Insbesondere MOS - gesteuerte Halbleiterchips können nur mit relativ kleinen aktiv steuerbaren Flächen bzw. Schaltleistungen hergestellt werden. Deshalb werden z. B. für ein 1200 A - Modul typischerweise 20 IGBTs zu einem Leistungshalbleitermodul parallelgeschaltet.

Ein derartiges Leistungshalbleitermodul bzw. Leistungsteil ist z. B. aus der EP - A1 - 0 597 144 bekannt. Zur Parallelschaltung mehrerer Submodule und für ihren Anschluss nach aussen wird ein hybrider leistungselektronischer Aufbau vorgeschlagen. Ein Submodul trägt auf einem Substrat mehrere, typischerweise 4 - 6 Leistungshalbleiter, die zu einer funktionalen Einheit zusammengeschaltet sind. Auf einer gemeinsamen Trägerplatte sind die Submodule zusammen mit einer Stapelanordnung induktionsarmer Leiterbahnschichten mit dazwischenliegenden Isoliermaterialschichten montiert. Die Trägerplatte ist vorzugsweise als Kühlkörper ausgeführt. Durch diesen Aufbau wird ein mechanisch stabiles, thermisch belastbares Leistungshalbleitermodul realisiert.

Die Submodule sind gehäuselos ausgeführt, um die Kontaktierung mit den Leiterbahnen zu vereinfachen. Bevorzugt werden Drahtbondverbindungen benutzt, aber auch Klemmkontakte oder alternative Verbindungen sind möglich. Zum Schutz der Submodule und Kontaktierungen wird auch vorgeschlagen, die montierten Submodule mit dem Leistungshalbleitermodul zu vergiessen.

Dieser bekannte Modulaufbau hat erhebliche Nachteile. Die Submodule sind vor der Montage auf der Trägerplatte besonders leicht beschädigbar. Beim Funktionstest hat der Ausfall eines Halbleiterchips den Verlust des ganzen Submoduls zur Folge. Es sind relativ grosse Keramiksubstrate und damit auch grossflächige, thermisch problematische Lotverbindungen zur Trägerplatte erforderlich. Die Drahtbondverbindungen zwischen Submodulen und Leiterbahnen müssen bezüglich Stromtragfähigkeit und Temperaturzyklen sehr belastbar sein, was speziellen Aufwand und grosse Sorgfalt beim Bondierungsprozess erfordert. Gleichwohl bleiben auf dem Leistungshalbleitermodul offenliegende Drahtbondverbindungen sehr fragil. Sind sie vergossen, so ist der Ersatz eines Submoduls schwierig oder unmöglich, d. h. bei Versagen eines einzigen Halbleiterchips muss das ganze Leistungshalbleitermodul ausgetauscht werden. Im Betrieb können zudem durch ausfallende Chips überlastete Bondierungen sich ablösen, Lichtbögen zünden, das Substrat durchschmelzen und gefährliche Kurzschlüsse zwischen Leiterbahnen und dem Kühler verursachen.

Leistungshalbleitermodule mit geschlossenem Gehäuse sind z. B. aus der DE - PS - 36 69 017 bekannt. Sie haben einen relativ komplizierten Aufbau mit mehreren Halbleiterbauelementen, internen Verdrahtungen, externen Anschlusslaschen, keramischen Stützern, usw. Sie sind von einem Gehäuse, typischerweise aus Kunststoff, mit Durchführungen für die Anschlüsse umgeben und innen mit weichem Gel, hartem Epoxy oder einer Kombination vergossen.

Eine solche Gehäusekapselung ist sehr aufwendig herzustellen und wenig zuverlässig. Insbesondere schützt die Weichvergiessmasse nur unzureichend vor Feuchtigkeit oder Korrosion, wohingegen die Hartvergiessmasse im Falle einer Explosion Partikel emittieren und grossen Schaden anrichten kann.

### DARSTELLUNG DER ERFINDUNG

Aufgabe der vorliegenden Erfindung ist es, ein verbessertes Leistungshalbleitermodul mit mehreren Submodulen anzugeben, welches sich durch einen sehr einfachen und flexiblen Aufbau, Robustheit und leichte Austauschbarkeit der Submodule und sehr gute elektrische und thermische Belastbarkeit auszeichnet. Diese Aufgabe wird erfindungsgemäss durch die Merkmale des Anspruchs 1 gelöst.

Kern der Erfindung ist es nämlich, Leistungshalbleitermodule aus Submodulen aufzubauen, die sich durch eine Kapselung mit Aussenelektroden für einen oder wenige Leistungshalbleiter auszeichnen, die auf einer gemeinsamen Bodenplatte reversibel befestigbar und mit von aussen anschliessbaren, induktionsarmen Leitern reversibel kontaktierbar sind.

Ein Ausführungsbeispiel zeigt ein Submodul mit einer Kapselung, die sich durch zwei Aussenelektroden in Form eines metallisierten Substrats und einer Metallplatte und durch einen Verguss aus einer elektrisch isolierenden Masse auszeichnet.

Ein weiteres Ausführungsbeispiel stellt einen bevorzugten Aufbau eines Leistungshalbleitermoduls dar, bei dem durch Vorsprünge und Ausnehmungen in einer Stapelanordnung von Leiterbahnen Klemmkontakte gebildet werden, welche die Submodule haltern und kontaktieren.

Andere Ausführungsbeispiele ergeben sich aus den abhängigen Ansprüchen.

Ein Vorteil des erfindungsgemässen Leistungshalbleitermoduls besteht in seiner verbesserten Modularität, Wartungsfreundlichkeit und Skalierbarkeit zu höheren oder tieferen Schaltleistungen.

Ein weiterer Vorteil des erfindungsgemässen Leistungshalbleitermoduls besteht darin, dass trotz der sehr einfachen Auswechselbarkeit der Submodule eine sehr gute elektrische und thermische Ankopplung der Chips erreicht wird.

Besonders vorteilhaft ist eine verbesserte Wechsellastfestigkeit aufgrund der Druckkontaktierung der Submodule und im Fehlerfall ein günstiges, niederohmiges Kurzschlussverhalten.

Ferner ist ein wichtiger Vorteil der Erfindung auch darin zu erkennen, dass gekapselte Submodule als Standardteile herstellbar und testbar sind, wodurch Materialverluste und Kosten reduziert werden können.

### KURZE BESCHREIBUNG DER ZEICHNUNG

Die Erfindung wird nachstehend anhand von Ausführungsbeispielen erläutert. Es zeigen:
- Fig. 1: einen Schnitt durch ein erfindungsgemässes Submodul;
- Fig. 2: einen Schnitt durch ein erfindungsgemässes Leistungshalbleitermodul mit Submodulen gemäss Fig. 1;
- Fig. 3: ein bekanntes Schaltschema eines IGBT mit Freilaufdiode für eine bevorzugte Bestückung eines Submoduls gemäss Fig. 1.

In den Figuren sind gleiche Teile mit gleichen Bezugszeichen versehen.

### WEGE ZUR AUSFÜHRUNG DER ERFINDUNG

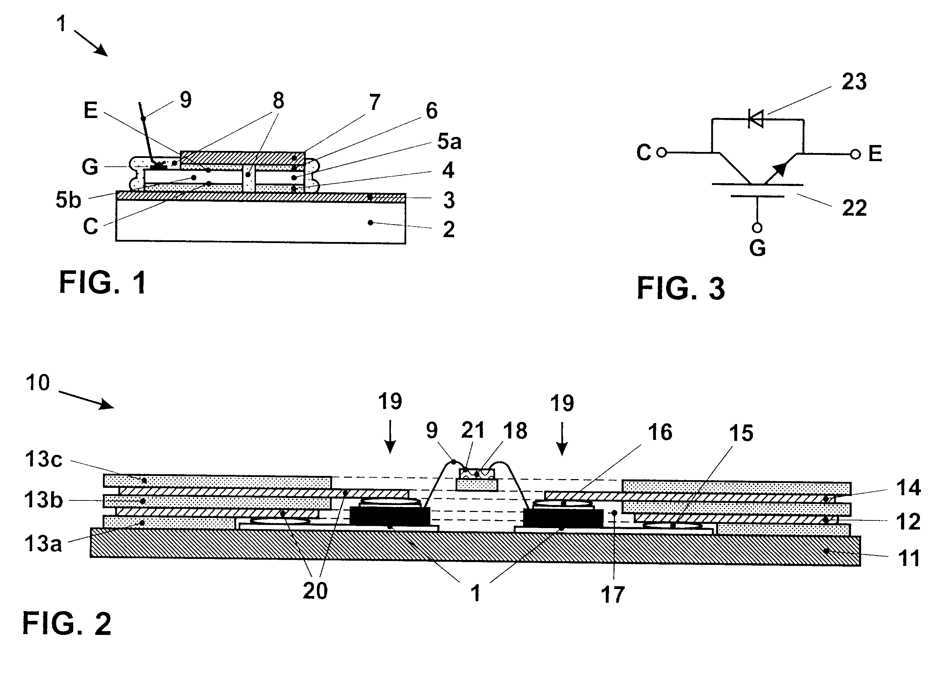

Fig. 1 zeigt eine bevorzugte Ausführungsform eines Submoduls 1, wie es Gegenstand der Erfindung ist. Auf einem Keramiksubstrat 2 ist mit einem üblichen Verfahren, z. B. DCB (direct copper bonding), eine Metallisierung 3 aufgebracht. Leistungshalbleiterchips 5a, 5b sind mit einem Leistungskontakt C über eine Lotschicht 4 mit der Metallisierung 3 und auf der gegenüberliegenden Flachseite mit einem Leistungskontakt E über eine weitere Lotschicht 6 mit einer Molybdänscheibe 7 zusammengelötet. Ein Steuer- oder Gatekontakt G des Chips 5b ist mit einem Bondierungsdraht 9 verbunden. Chip 5a und 5b sind so mit Plastik 8 vergossen, dass sie allseitig oder zumindest weitgehend durch das Keramiksubstrat 2, die Molybdänscheibe 7 und den Verguss 8 umschlossen sind.

Durch diese Kapselung bildet das Submodul 1 eine mechanisch stabile, gegen äussere Einflüsse geschützte Einheit. Zudem dienen ein vorstehender Teil des metallisierten Substrats 2 und die Molybdänscheibe 7 dem Submodul 1 als Aussenelektroden 3, 7.

In Fig. 2 ist eine bevorzugte Ausführungsform eines Leistungshalbleitermoduls mit derartig gekapselten Submodulen dargestellt. Auf einer Bodenplatte 11 ist eine Stapelanordnung zweier Leiter 12, 14 mit dazwischenliegenden Isolierschichten 13a, 13b, 13c montiert. Ausschnitte in der Stapelanordnung sind als Steckplätze 19 für die Submodule 1 ausgestaltet. Anschlussflächen 20 zur Kontaktierung der Aussenelektroden 3, 7 der gekapselten Submodule 1 werden durch zungenförmig hervorstehende oder nutenförmig ausgenommene Bereiche der Leiter 12, 14 gebildet. Die Halterung der Submodule 1 erfolgt über Federkontakte 15, 16 an den Anschlussflächen 20. Durch den Anpressdruck besteht auch ein guter Wärmekontakt der Submodule 1 bzw. ihrer Keramiksubstrate 2 zur wärmeabführenden Bodenplatte 11. Die Bondierungsdrähte 9 sind über Klemmkontakte 21 an einen gemeinsamen, in symmetrischer Mittenposition angeordneten Gateblock (gate runner) 18 angeschlossen, der z. B. als PCB (printed circuit board) ausgeführt ist.

Fig. 3 zeigt ein bekanntes Schaltschema für das Zusammenwirken eines IGBT 22 mit einer Leistungshalbleiterdiode 23. Diese Kombination von Leistungshalbleiterchips 5a, 5b stellt eine bevorzugte Bestückung für ein gekapseltes Submodul 1 dar. Dabei sind die jeweiligen Leistungskontakte C, E beider Elemente, nämlich Kollektor und Kathode sowie Emitter und Anode, kurzgeschlossen und mit den Aussenelektroden 3 sowie 7 der Submodule 1 verbunden.

Die Erfindung umfasst auch weitere Ausführungsformen der Submodule 1 und Leistungshalbleitermodule 10, von denen einige nachfolgend näher erläutert werden.

Die Bestückung eines Submoduls 1 umfasst mindestens ein Leistungshalbleiterbauelement, wie z. B. Thyristor, GTO, MCT, Leistungsdiode, IGBT oder MOSFETS, wobei unter Umständen der Gatekontakt G, Bondierungsdraht 9 und Gateblock 18 wegfallen. Ein Submodul 1 kann aber auch andere Beschaltungskomponenten beinhalten. Jedoch soll ein Submodul 1 nur wenige Elemente enthalten, um den Vorteil der Modularität und Flexibilität zu wahren. Besonders wünschenswert ist eine minimale Bestückung, bei der noch eine volle Funktionalität und Testbarkeit eines Submoduls 1 gewährleistet ist, aber Mehrfachbestückungen zur Leistungserhöhung eines Submoduls 1 vermieden werden.

Das Substrat 2 kann aus irgendeinem elektrisch isolierenden und hinreichend wärmeleitenden Material, insbesondere aus AlN, bestehen. Die Scheibe 7 kann aus Molybdän, anderen Metallen, Legierungen oder anderen Materialien mit metallischer Leitfähigkeit bestehen, sofern der thermische Ausdehnungskoeffizient dem des Halbleitermaterials hinreichend ähnlich ist. Anstelle der Lotschichten 4, 6 und der Bondierungsdrähte 9 sind auch andere Verbindungstechniken anwendbar, sofern eine mechanisch stabile Kontaktierung der Chips 5a, 5b erreicht wird. Ein Submodul 1 kann auch mehrere Bondierungsdrähte 9 und allgemein mehrere Gateanschlüsse 9 für einen oder mehrere Gatekontakte G aufweisen. Die Kontaktierung am Gateblock 18 kann anstatt mit Klemmkontakten 21 auch mit Steckern oder anderen leicht lösbaren Kontakten realisiert sein.

Der Verguss 8 kann statt aus Plastik auch aus einer anderen elektrisch isolierenden Vergussmasse bestehen und wird vorzugsweise durch ein Spritzpressverfahren (transfer moulding) hergestellt. Insbesondere soll der Verguss 8 auch den bondierten Gatekontakt G schützen und darüberhinaus den herausgeführten Bondierungsdraht bzw. Gateanschluss 9 mechanisch stützen. Die Gestalt des Vergusses 8 und damit des Submoduls 1 ist so gewählt, dass die spezifizierten Kriechwege und Isolationsstrecken in Luft oder Gas eingehalten werden können. Das Substrat 2 und die Metallplatte 7 sind Bestandteile der Submodulkapselung und sollen zur mechanischen Stabilität der Kapselung beitragen. Dafür ist es von Vorteil, wenn das Substrat 2 und die Metallplatte 7 so grossflächig gewählt werden, dass sie einen wesentlichen Teil des mindestens einen Chips 5a, 5b abdecken.

Die durch die Metallisierung 3 und die Metallplatte 7 gebildeten Aussenelektroden 3, 7 sind am einfachsten flächenhaft ausgebildet, können aber auch überstehende oder abstehende Teile oder Laschen umfassen. Wichtig ist, dass eine zuverlässige, leicht lösbare Verbindung für hohe Ströme zwischen den Aussenelektroden 3, 7 und den Leitern 12, 14 sichergestellt ist.

Der Aufbau des Leistungshalbleitermoduls 10 kann insbesondere hinsichtlich der Anordnung von Submodulen 1 und der Stapelanordnung von Leitern 12, 14 variiert werden. Je nach geforderter Schaltleistung bzw. Anzahl von Submodulen 1 können die Grösse und Form der Bodenplatte 11, der Stapelanordnung und eines oder mehrerer Gateblocks 18 angepasst werden. Es können ein oder mehrere Reihen nebeneinanderliegender Steckplätze 19 für Submodule 1 bereitgestellt sein. Erfindungsgemässe gekapselte und steckbare Submodule 1 können auch mit bekannten offenen oder fest montierten Submodulen kombiniert werden. Die Submodule 1 können auch angeschraubt oder anderweitig reversibel befestigt sein. Die Stapelanordnung kann Isolierschichten 13a, 13b, 13c aus Feststoff-, Luft- oder Gasisolation umfassen, sofern die Leiter 12, 14 ausreichend beabstandet sind. Der Gateblock 18 kann durch eine dritte Schicht mit Leiterbahnen z. B. in PCB - Technik ersetzt werden. Die Leiterbahnen können sich in Ebenen erstrecken oder abgewinkelt sein und Laschen für den Anschluss von Stromschienen aufweisen. Dabei ist es besonders für Submodule 1 mit schnell schaltenden Chips 5a, 5b wie z. B. IGBTs 22 wichtig, dass die Leiterbahnen 12, 14, aber auch sämtliche Anschlüsse, niederinduktiv ausgelegt sind. Zur Druckkontaktierung der Aussenelektroden 3, 7 der Submodule 1 können auch die Anschlussflächen 20 selber flexibel und federnd gestaltet sein und die Federkontakte 15, 16 weggelassen werden. Schliesslich ist die Bodenplatte 11 vorteilhafterweise als Kühler ausgebildet oder mit einem Kühler in thermischer Verbindung. Der Kühler kann als Kühlkörper mit Rippen, als Flüssigkeitskühler oder ähnlich aufgebaut sein.

Prinzipiell ist es auch denkbar, Submodule 1 platzsparend in mehreren Ebenen übereinander anzuordnen und über eine mehrstöckige Stapelanordnung von Leiterbahnen 12, 14 zu kontaktieren, wobei eine ausreichende Wärmeableitung z. B. über Wärmebrücken zu jedem Submodule 1 gewährleistet sein muss.

Erfindungsgemässe Leistungshalbleitermodule weisen neben den eingangs erwähnten Vorteilen insbesondere folgende Vorzüge auf. Nach der Kapselung der Submodule 1 sind keine weiteren Bondierungen oder Lötungen notwendig. Insbesondere entfällt die Lotschicht zwischen den grossflächigen Keramiksubstraten herkömmlicher Submodule und der Bodenplatte 11. Die Gefahren durch sich ablösende Bondierungen oder thermomechanisch überstrapazierter Lötverbindungen sind somit weitgehend reduziert. Nach Montage der Submodule 1 im Leistungshalbleitermodul 10 ist kein weiterer Verguss erforderlich, da keine Komponenten oder Kontaktierungen mechanisch oder elektrisch geschützt werden müssen. Vielmehr genügt für die spannungstragenden Teile 3, 7, 15, 16, 20 im Bereich der Steckplätze 19 eine Luftisolation 17. Wegen der flexiblen Druckkontaktierungen 15, 16, 20 zeichnet sich das erfindungsgemässe Leistungshalbleitermodul 10 durch eine sehr hohe thermische Wechselbelastbarkeit aus. Beim Ausfall von Leistungshalbleiterchips 5a, 5b kann das entsprechende Submodule 1 einen niederohmigen Kurzschluss bilden. Dies reduziert die Explosionsgefahr oder mildert zumindest das Explosionsverhalten. Darüberhinaus ist ein niederohmiges Kurzschlussverhalten besonders dann von Vorteil, wenn die erfindungsgemässen Submodule 1 in Serienschaltungen eingesetzt werden.

### BEZUGSZEICHENLISTE

- 1: geschlossenes Submodul
- 2: Keramiksubstrat
- 3, 7: Aussenelektroden (eines Submoduls)
- 3: Metallisierung
- 4, 6: Lotschicht
- 5a, 5b: Leistungshalbleiterchips
- 7: Molybdänscheibe
- 8: Plastikverguss, isolierende Vergussmasse
- 9: Bondierungsdraht, Gateanschluss
- 10: Leistungshalbleitermodul
- 11: Bodenplatte, Kühler
- 12, 14: Leiter
- 13a, 13b, 13c: Feststoffisolation, Isolierschichten
- 15, 16: Federkontakte, Kontakte
- 17: Luftisolation, Gasisolation
- 18: Gateblock (gate runner)
- 19: Steckplätze für Submodule
- 20: Anschlussflächen
- 21: Klemmkontakte
- 22: IGBT
- 23: Leistungshalbleiterdiode
- C, E: Leistungskontakte
- c: Kollektor, Kathode
- E: Emitter, Anode
- G: Steuerkontakt, Gatekontakt

## Patentansprüche

1. Leistungshalbleitermodul (10) mit einer Mehrzahl von Submodulen (1) mit jeweils mindestens einem Halbleiterchip (5a, 5b), welche Submodule (1) auf einer gemeinsamen, wärmeabführenden Bodenplatte (11) gehaltert und mit von aussen anschliessbaren Leitern (12, 14, 18) elektrisch kontaktiert sind, dadurch gekennzeichnet, dass
a) der mindestens eine Halbleiterchip (5a, 5b) eines Submoduls (1) in einem Gehäuse gekapselt ist,
b) die Kapselung der Submodule (1) Aussenelektroden (3, 7) für Leistungskontakte (C, E) des mindestens einen Halbleiterchips (5a, 5b) aufweist und
c) die Halterung und Kontaktierung jedes gekapselten Submoduls (1) auf dem Leistungshalbleitermodul (10) leicht lösbar sind.

2. Leistungshalbleitermodul nach Anspruch 1, dadurch gekennzeichnet, dass
a) die Kapselung der Submodule (1) einen Verguss (8) aus einer elektrisch isolierenden Masse umfasst,
b) die Aussenelektroden (3, 7) flächenhaft ausgebildet sind und
c) insbesondere ein Gateanschluss (9) für einen Gatekontakt (G) des mindestens einen Halbleiterchips (5a, 5b) durch den Verguss (8) herausgeführt ist.

3. Leistungshalbleitermodul nach einem der Ansprüche 1 oder 2, dadurch gekennzeichnet, dass
a) die Kapselung der Submodule (1) ein elektrisch isolierendes Substrat (2) mit einer Metallisierung (3) und eine Metallplatte (7) umfasst,
b) der mindestens eine Halbleiterchip (5a, 5b) mit seinen Leistungskontakten (C, E) vorzugsweise über Lotschichten (4, 6) mit der Metallisierung (3) und der Metallplatte (7) elektrisch verbunden ist und
c) die Aussenelektroden (3, 7) einen überstehenden Teil des metallisierten Substrats (2) und die Metallplatte (7) umfassen.

4. Leistungshalbleitermodul nach Anspruch 3, dadurch gekennzeichnet, dass
a) ein Submodul (1) eine minimale Bestückung mit Halbleiterchips (5a, 5b), insbesondere einen IGBT (22) und/oder eine Leistungsdiode (23), aufweist,
b) das Substrat (2) ein keramisches Material enthält,
c) die Metallplatte (7) Molybdän enthält,
d) die Vergussmasse (8) aus Plastik besteht und
e) ein Gateanschluss (9) ein Bondierungsdraht ist.

5. Leistungshalbleitermodul nach einem der Ansprüche 1 - 4, dadurch gekennzeichnet, dass
a) die Leiter (12, 14) über der Bodenplatte (11) in einem Stapel induktionsarm angeordnet und untereinander für eine elektrische Isolation (13a, 13b, 13c, 17) ausreichend beabstandet sind,
b) Ausschnitte in der Stapelanordnung mit zungenförmig hervorstehenden oder nutenförmig ausgenommenen Leiterbereichen als Steckplätze (19) und Anschlussflächen (20) für gekapselte Submodule (1) ausgestaltet sind und
c) insbesondere Gatekontakte der gekapselten Submodule (1) über Gateanschlüsse (9) mit einem Gateblock (18) verbunden sind.

6. Leistungshalbleitermodul nach Anspruch 6, dadurch gekennzeichnet, dass
a) die Leiter (12, 14) durch eine Feststoffisolation (13a, 13b, 13c) und im Bereich der Steckplätze (19) durch eine Luft- oder Gasisolation (17) beabstandet sind,
b) eine Druckkontaktierung der Aussenelektroden (3, 7) der Submodule (1) durch die Anschlussflächen (20) vorgesehen ist und
c) insbesondere die Anschlussflächen (20) mit Federkontakten (15, 16) ausgestattet sind.

7. Leistungshalbleitermodul nach einem der Ansprüche 3 - 6, dadurch gekennzeichnet, dass
a) die Bodenplatte (11) als Kühler ausgebildet ist oder mit einem Kühler in thermischer Verbindung steht,
b) das Substrat (2) eine gute Wärmeleitfähigkeit aufweist und
c) die Submodule (1) nebeneinander mit einem guten Wärmekontakt zur Bodenplatte (11) befestigbar sind.

8. Leistungshalbleitermodul nach einem der Ansprüche 1 - 7, dadurch gekennzeichnet, dass eine Anzahl von Submodulen (1) nach Massgabe einer geforderten Schaltleistung des Leistungshalbleitermoduls (10) gewählt ist.
